Europäisches Patentamt

European Patent Office

Office européen des brevets

(19)

(11) **EP 1 002 334 B1**

(12) **EUROPÄISCHE PATENTSCHRIFT**

(45) Veröffentlichungstag und Bekanntmachung des Hinweises auf die Patenterteilung:
**29.09.2004 Patentblatt 2004/40**

(51) Int Cl.[7]: **H01L 21/3105**, H01L 21/311, H01L 21/336

(21) Anmeldenummer: **98947345.9**

(22) Anmeldetag: **27.07.1998**

(86) Internationale Anmeldenummer:
**PCT/DE1998/002110**

(87) Internationale Veröffentlichungsnummer:
**WO 1999/007011 (11.02.1999 Gazette 1999/06)**

(54) **VERFAHREN ZUR STRUKTURIERUNG VON HALBLEITERN MIT HOHER PRÄZISION, GUTER HOMOGENITÄT UND REPRODUZIERBARKEIT**

METHOD FOR CONFIGURING SEMICONDUCTORS WITH HIGH PRECISION, GOOD HOMOGENEITY AND REPRODUCIBILITY

PROCEDE DE STRUCTURATION DE SEMI-CONDUCTEURS, AVEC UNE HAUTE PRECISION, UNE BONNE HOMOGENEITE ET UNE BONNE REPRODUCTIBILITE

(84) Benannte Vertragsstaaten:
**DE FR IT**

(30) Priorität: **31.07.1997 DE 19733068**

(43) Veröffentlichungstag der Anmeldung:
**24.05.2000 Patentblatt 2000/21**

(73) Patentinhaber: **SiCED Electronics Development GmbH & Co KG**
**91052 Erlangen (DE)**

(72) Erfinder:
• **PETERS, Dethard**
  **D-91315 Höchstadt (DE)**

• **SCHÖRNER, Reinhold**
  **D-91091 Grossenseebach (DE)**

(74) Vertreter: **Berg, Peter, Dipl.-Ing. et al**
**European Patent Attorney,**
**Siemens AG,**
**Postfach 22 16 34**
**80506 München (DE)**

(56) Entgegenhaltungen:
**EP-A- 0 589 631          US-A- 4 430 792**
**US-A- 5 648 283**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

**Beschreibung**

Die Erfindung bezieht sich auf ein Verfahren zur Herstellung von Halbleiter-Strukturen aus Silizium-Carbid.

Bei Leistungshalbleiterbauelementen, z.B. Leistungs-MOSFETs (*Metal-Oxide-Semiconductor Field Effect Transistor*), wird an die Homogenität besonders hohe Anforderungen gestellt, weil häufig viele als Zellen bezeichnete Teile dieser Elemente parallel geschaltet werden und jede Zelle den gleichen Anteil zum Gesamtstrom beitragen soll.

Bei einem aus der Silizium-Technik an sich bekannten Aufbau einer vertikalen MOSFET-Zelle mit einem sogenannten lateralen Kanalgebiet wird eine sogenannte Kanallänge definiert durch den lateralen Überlapp eines Basisgebiets über ein Source-Gebiet des MOSFETs mit entgegengesetztem Leitungstyp. Zur Erzielung eines niedrigeren Kanalwiderstands trachtet man danach, die Kanallänge der MOSFET-Zelle zu minimieren. Für eine Massenfertigung von Bauelementen mit wenigstens annähernd identischen Eigenschaften ist es ferner erforderlich, daß die Kanallänge über den gesamten Wafer aus dem Halbleitermaterial zumindest weitgehend homogen ist und von Wafer zu Wafer reproduzierbar eingestellt werden kann.

Aus dem Buch von *"B.J. Baliga", Modern Power Devices, Krieger, Publishing Comp., 1992, Seiten 331-336* ist ein selbstjustierendes Verfahren zur Herstellung von vertikalen MOSFET-Bauelementen in Silizium bekannt. Im beschriebenen Verfahren zur Herstellung eines DMOS-FET (double-diffused MOSFET) wird auf eine durch Epitaxie erzeugte Siliziumschicht vom n-Leitungstyp zunächst ein MOS-System (Gate-Oxid und Gate-Elektrode) präpariert. Das MOS-System wird in gewünschter Weise photolithographisch strukturiert und bildet eine Maske mit definierten Zell-Fenstern für die nachfolgende Implantation von Bor-Ionen. Anschließend wird eine Hilfsmaskierung aufgebracht, welche jeweils in der Mitte der Zell-Fenster einen Teil der zuvor implantierten p-dotierten Basis-Gebiete maskiert und so von der Oberfläche der Halbleiterstruktur her zugänglich hält. Das so modifizierte Maskensystem dient als Maske für einen weiteren Implantationsschritt (üblicherweise mit Arsen), der die n-dotierten Source-Gebiete der Struktur definiert. Die Kanallänge der Struktur resultiert aus den unterschiedlichen Diffusionskoeffizienten des langsamen Donators und des schnellen Akzeptors. Über Temperatur und Dauer des Ausheilprozesses kann die Kanallänge selbstjustierend eingestellt werden. Das MOS-System wird durch diesen Hochtemperaturschritt nicht oder nur unwesentlich in Mitleidenschaft gezogen. Nach dem thermischen Ausheilen der implantierten Dotierstoffe wird auf die Struktur eine isolierende Oxidschicht aufgebracht. In der Oxidschicht werden, justiert auf die Hilfsmaskierung, photolithographisch Kontaktfenster geöffnet. Abschließend wird die Oberfläche metallisiert. Dieses Verfahren ist im Bezug auf die Einstellung der Kanallänge unkritisch. Es benötigt lediglich zwei relativ unkritische Justierschritte bei der Aufbringung der Hilfsmaskierung und dem Öffnen der Kontaktfenster, ist allerdings nicht auf Halbleiter anwendbar, bei denen praktisch keine Diffusion stattfindet, wie z.B. SiC oder Diamant.

In *"Self aligned 6H-SiC MOSFETs with improved current drive", J.N. Pan, J.A. Cooper, M.R. Melloch, Electronics letters, 6. Juli 1995, Vol. 31, Nr. 14, S. 1200-1201* ist ein Verfahren zur Herstellung eines lateralen MOSFETs in Silizium-Carbid des Kristall-Typs 6H (6H-SiC) beschrieben. Gemäß diesem Verfahren definieren benachbarte Fenster in einer Maskenebene innerhalb einer epitaktisch aufgewachsenen, p-dotierten 6H-SiC-Schicht paarweise Source- und Drain-Gebiete einer Einheitszelle, die jeweils mittels Implantation von Stickstoffionen n-dotiert werden.

Da für SiC aber im Vergleich zu Silizium (750° C -800° C) deutlich höhere Temperaturen (1200° C -1500° C) zum Ausheilen und Aktivieren der implantierten Dotierstoffe erforderlich sind, ist die Verwendung des MOS-Systems als Maskierung problematisch. Um das MOS-System nicht zu schädigen, kann nur bei Temperaturen bis maximal 1200° C getempert werden. Zudem ist die Diffusion in SiC vernachlässigbar klein, so daß keine dem Siliziumverfahren entsprechende selbstjustierende Kontrolle über eine Kanallänge besteht. Somit ist eine Implantation von Akzeptor-Ionen nicht möglich. Die Kanallänge wird über den Abstand der Fenster in der Maske eingestellt, und das Gate-Oxid und die Gate-Elektrode liegen selbstjustiert über dem Inversionskanal. Das Verfahren ist nicht anwendbar auf solche Bauelementtypen, bei denen ein Kanalgebiet implantiert wird, weil dazu entweder für Source und Drain oder für das Kanalgebiet eine p-Dotierung notwendig ist. Die maximal mögliche Ausheiltemperatur von 1200° C reicht aber für eine Ausheilung der Gitterschädigung und Aktivierung der Akzeptor-Ionen nicht aus.

In *"4H-Silicon Carbide Power Switching Devices", J.W. Palmour et.al., Technical digest of International conference on SiC and related materials, Kyoto, 1995, S. 319-322* wird die Herstellung einer nicht planaren UMOS-Struktur beschrieben. Die Source-Gebiete werden durch Implantation von Donator-Ionen in eine epitaktisch gewachsene p-dotierte Sie-Schicht definiert. Durch reaktives Ionenätzen (Reactive Ion Etching, RIE) wird, jeweils auf die Mitte der Source-Gebiete justiert, ein U-förmiger Graben in der Oberfläche der Halbleiterstruktur geöffnet. Die Gräben reichen jeweils hinunter bis in die unter der p-dotierten SiC-Schicht angeordnete n-dotierte SiC-Schicht und nehmen Gate-Oxid und Gate-Elektrode auf. Die Kanallänge wird durch die in vertikaler Richtung zwischen Source-Gebiet und n-dotierter SiC-Schicht verbleibende Dicke der p-dotierten SiC-Schicht definiert. Auch bei diesem Verfahren ist nur ein einziger Implantationsschritt vorgesehen. Die Kanallänge wird über die Eindringtiefe der Stickstoff-Ionen und die Dikke der p-dotierten SiC-Schicht kontrolliert.

Ein lateral angeordnetes Kanalgebiet läßt sich mit diesem Verfahren nicht realisieren.

Ein weiteres Verfahren zur selbstjustierten Herstellung einer Halbleiterstruktur in Silizium mit zwei Implantationsschritten ist in "*A low loss/highly rugged IGBT-Generation - based on a self aligned process with double implanted n/n$^{+-}$Emitter*", *Proc. of the 6$^{th}$ international Symposium on power semiconductor devices & ICs, Davos, 1994, Seite 171-175* vorgestellt. Das Verfahren zeichnet sich dadurch aus, daß nach einem Implantationsschritt eine aus der Siliziumtechnologie bekannte Spacer-Technik angewendet wird. In einem CVD-Prozeß werden die zuvor in die Maskenebene eingeätzten Fenster von deren Rand aus gleichmäßig um einen definierten Betrag zwischen 0,4 µm und 0,6 µm verkleinert. Mit diesen verkleinerten Fenstern können dann in einem folgenden Implantationsschritt weitere Halbleitergebiete erzeugt werden, die alle jeweils zu einem durch den ersten Implantationsschritt erzeugten Halbleitergebiet bis auf 0,3 µm genau selbstjustiert sind. Nachteilig bei diesem beschriebenen Verfahren ist, daß es nicht mehrfach hintereinander anwendbar ist, und mittels der Spacer-Technik nur Verkleinerungen der Fenster bis maximal 1 µm möglich sind. Zudem sind Abscheideverfahren und Abtrag der Hilfsschichten zeit- und kostenaufwendig.

Die der Erfindung zugrunde liegende Aufgabe ist es, ein selbstjustierendes Verfahren zur Strukturierung von Silizium-Carbid Halbleitern anzugeben, mit dem in einer Halbleiteranordnung die räumliche Anordnung wenigstens zwei verschiedener Halbleiter-Teilgebiete mit unterschiedlichen elektronischen Eigenschaften mit zum Stand der Technik mindestens vergleichbarer Präzision, Homogenität und Reproduzierbarkeit eingestellt werden können.

Die Aufgabe wird gemäß der Erfindung gelöst mit den Merkmalen des Anspruchs 1.

Das erfindungsgemäße Verfahren zur Herstellung von Halbleiterstrukturen ist ein Verfahren, bei dem

a) ein Dünnschichtsystem aus mindestens zwei Teilschichten auf die Oberfläche eines Halbleitergebiets abgeschieden wird, wobei zumindest für die an die Oberfläche des Halbleitergebiets unmittelbar angrenzende erste Teilschicht ein Oxidmaterial vorgesehen ist, und für das Halbleitergebiet Silizium-Carbid verwendet wird,

b) mit einem Ätzverfahren mindestens ein bis zur Oberfläche des Halbleitergebiets reichendes Fenster in das Dünnschichtsystem eingeätzt wird,

c) das mindestens eine Fenster im Dünnschichtsystem für eine erste selektive Bearbeitung eines Teilgebiets des Halbleitergebiets genutzt wird,

d) durch einen Unterätz-Prozeß wenigstens in der ersten Teilschicht des Dünnschichtsystems der Rand des mindestens einen Fensters in der Schichtebene jeweils annähernd gleichmäßig um einen Betrag zurückgenommen wird, der einer mittleren Unterätz-Tiefe entspricht,

e) das mindestens eine durch Unterätzen vergrößerte Fenster im Dünnschichtsystem für eine zweite selektive Bearbeitung eines weiteren Teilgebiets des Halbleitergebiets genutzt wird, und

f) das Dünnschichtsystem entfernt wird.

Die Erfindung beruht dabei auf der Erkenntnis, daß bei erfindungsgemäßer Wahl der Verfahrensschritte sämtliche Gebiete der Halbleiterstruktur, die einer selektiven Bearbeitung unterzogen werden sollen, über eine einzige Maskenebene relativ zueinander justiert sind. In diesem Sinne kann das Verfahren als selbstjustierend bezeichnet werden. Wesentlich für das Verfahren ist ein Unterätz-Prozeß, mit dem Fenster des Dünnschichtsystems jeweils annähernd gleichmäßig um einen Betrag in der Schichtebene zurückgenommen werden können. Lediglich bei der Kontaktierung der Halbleitergebiete mit Metall-Kontakten und beim Aufbringen zusätzlicher Oxidschichten bzw. Gate-Elektroden ist eine Justierung auf die ursprünglich in der Maskenebene definierten Fenster erforderlich.

Das Dünnschichtsystem besteht aus mindestens einer ersten und einer zweiten Dünnschicht, wobei die beiden Dünnschichten nacheinander auf die Oberfläche des zu strukturierenden Halbleitergebiets abgeschieden werden und aufgrund ihrer Materialeigenschaften sowohl gegeneinander als auch gegenüber dem Halbleitermaterial selektiv ätzbar sind. Beim erfindungsgemäßen Unterätz-Prozeß findet ein Abtrag des Dünnschichtsystems somit gleichmäßig in der Schichtebene einer ersten Schicht statt.

In dem Verfahren ist zumindest die erste Teilschicht des Dünnschichtsystems ein Oxidmaterial. Bevorzugt wird als Oxidmaterial Siliziumdioxid (SiO$_2$) verwendet, es sind aber auch andere Oxide oder Nitride, wie etwa Ti$_2$O$_3$, SiO, Ta$_2$O$_5$, Si$_3$N$_4$, denkbar, oder auch andere Materialien, die sich selektiv ätzen lassen. Weil das Halbleitermaterial zumindest teilweise Silizium(- Atome) enthält, kann vorteilhaft eine SiO$_2$-Schicht beispielsweise mit einem der bekannten Verfahren zur thermischen Oxidation der Halbleiteroberfläche auf einfache Weise hergestellt werden. Typischerweise besteht eine zweite oder auch weitere Schicht des Dünnschichtsystems aus Polysilizium oder spannungsarmem Si$_3$N$_4$.

Vorteilhafte Ausgestaltungen des erfindungsgemäßen Verfahrens ergeben sich aus den Unteransprüchen. Besonders vorteilhaft sind die nachfolgend angesprochenen Ausführungsformen.

In einer ersten, vorteilhaften Weiterbildung des Verfahrens wird nach einer zweiten selektiven Bearbeitung des Halbleitergebiets wenigstens einmal eine Abfolge von Verfahrensschritten angewandt, welche wenigstens die Verfahrensschritte des Unterätzens des Dünnschichtsystems sowie des selektiven Bearbeitens des Halbleitergebiets umfassen.

In einer vorteilhaften Ausgestaltung wird das Unterätzen durch naßchemisches Ätzen vorgenommen. Ein vorgegebener Sollwert der Unterätztiefe kann dann über die Ätzdauer eingestellt werden.

In einer besonders vorteilhaften Ausgestaltung wird als naßchemisches Ätzmittel gepufferte Flußsäure (BHF) verwendet. Die Unterätztiefe kann dann sehr genau kontrolliert werden, da die Ätzrate von BHF für $SiO_2$ beispielsweise bei 70 nm/min liegt, und das Ätzmittel die zu ätzenden Oberflächen gut benetzt.

In einer weiteren Ausführungsform des Verfahrens wird für das Öffnen des mindestens einen Fensters im Dünnschichtsystem ein Ätzverfahren verwendet, bei dem der Abtrag im wesentlichen in einer Vorzugsrichtung erfolgt, die einen definierten Neigungswinkel mit der Oberflächennormale einschließt.

In einer anderen, vorteilhaften Ausführungsform des Verfahrens werden in einem zusätzlichen Verfahrensschritt in den durch die Fenster im Dünnschichtsystem definierten Bereichen zusätzlich optisch erkennbare und gegenüber dem Ausheilen der Halbleiterstruktur beständige Ätzkanten in die Oberfläche des Halbleiters eingeätzt.

In einer weiteren, vorteilhaften Ausführungsform des Verfahrens wird vor jeder selektiven Bearbeitung eines Teilgebiets des Halbleitergebiets wenigstens auf Teile der Oberfläche des Halbleitergebiets eine Streuschicht aufgebracht. Bevorzugt wird für die Streuschicht $SiO_2$ verwendet.

In einer weiteren, vorteilhaften Ausführungsform des Verfahrens können durch Einstellung einer Unterätztiefe im Dünnschichtsystem je zwei aufeinander folgende Bearbeitungsvorgänge des zu strukturierenden Halbleitergebiets mit definierter Präzision, Homogenität und Reproduzierbarkeit vorgenommen werden, die zueinander zentriert sind.

Vorzugsweise gilt dann für die Präzision eines Unterätzvorgangs, daß die relative Ungenauigkeit der tatsächlichen Unterätztiefe (Abweichung einer tatsächlichen Unterätztiefe von einem Mittelwert der Unterätztiefe in einem Fenster) weniger als 10 nm beträgt.

In einer vorteilhaften Weiterbildung dieser Ausführungsform gilt für die Homogenität eines Unterätzvorgangs, daß die relative Ungenauigkeit der mittleren Unterätztiefe (Abweichung des jeweiligen Mittelwerts der Unterätztiefe von einem allen Fenstern gemeinsamen Mittelwert der mittleren Unterätztiefe) weniger als 10 nm beträgt. In einer besonders vorteilhaften Ausgestaltung gilt für die Reproduzierbarkeit eines Unterätzvorgangs, daß die effektive Unterätztiefe (Abweichung des allen Fenstern gemeinsamen Mittelwerts der mittleren Unterätztiefe von einem vorgegebenen Wert) weniger als 100 nm beträgt.

Zur weiteren Erläuterung der Erfindung wird Bezug genommen auf die Zeichnung, deren

Fig. 1 eine aus der Siliziumtechnologie an sich bekannte MOSFET-Halbleiterstruktur zeigt;

Fig. 2 und 3 jeweils eine perspektivische Ansicht des Querschnitts einer mit einem erfindungsgemäßen Verfahren bearbeitete Halbleiterstruktur zeigen, wobei

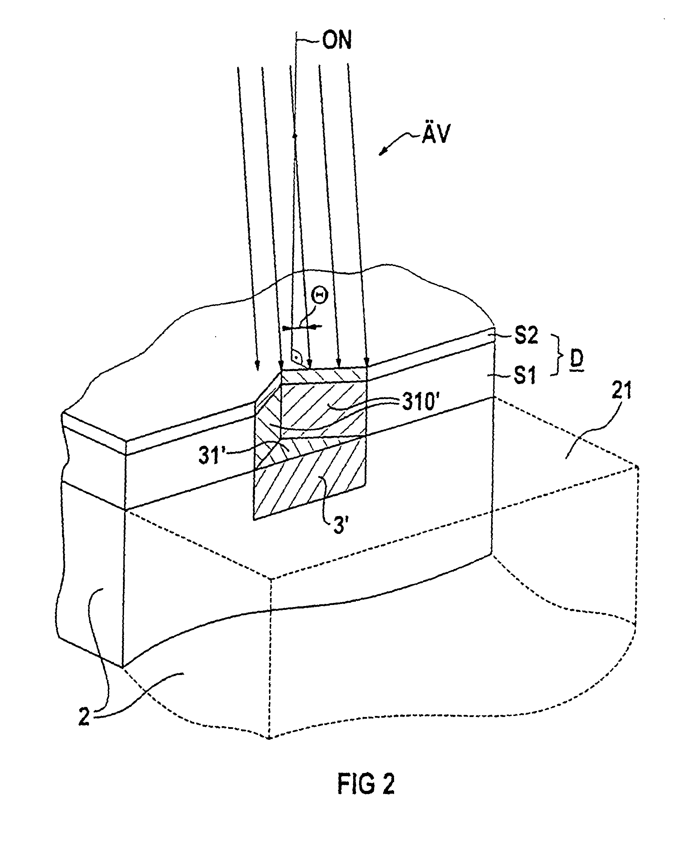

Fig. 2 das erfindungsgemäße Öffnen der Fenster im Dünnschichtsystem illustriert, und

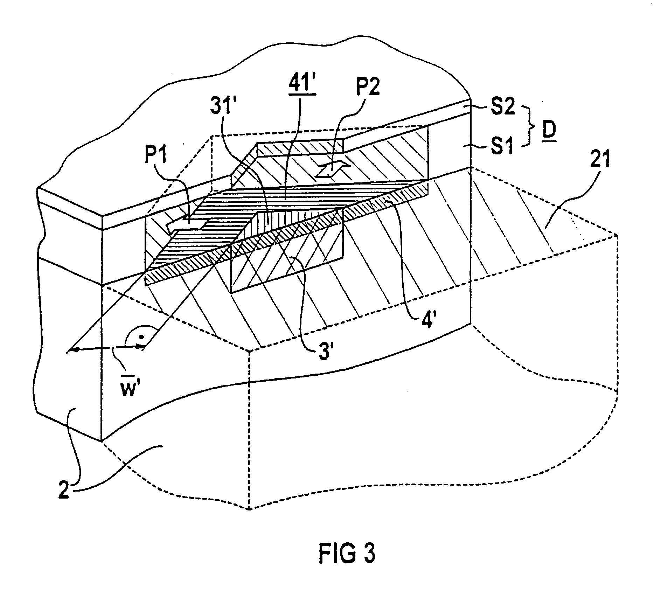

Fig. 3 den erfindungsgemäßen Unterätz-Prozeß zum Zurücknehmen des Rands eines Fensters illustriert;

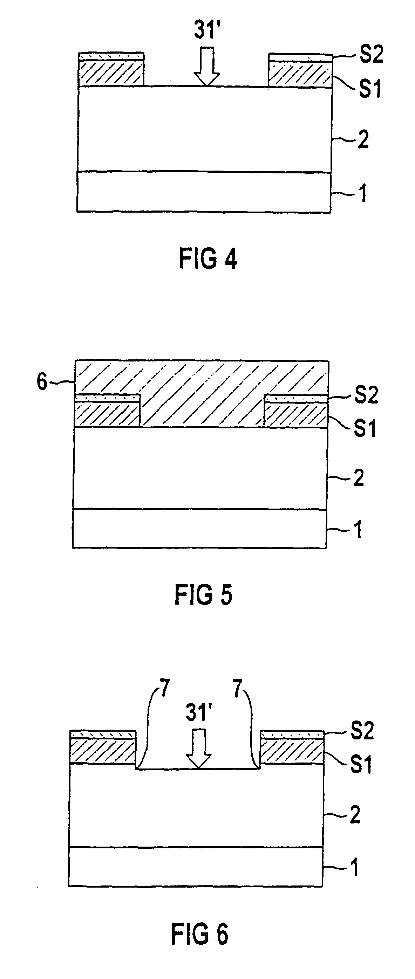

Fig. 4 bis Fig. 12 jeweils in einer zweidimensionalen Ansicht des Querschnitts einer Halbleiterstruktur den Ablauf eines erfindungsgemäßen Verfahrens andeutet, wobei

Fig. 4 bis 6 die zusätzlichen Verfahrensschritte zum optionalen Aufbringen von Justiermarken in den vom Dünnschichtsystem maskierten Bereichen zeigen,

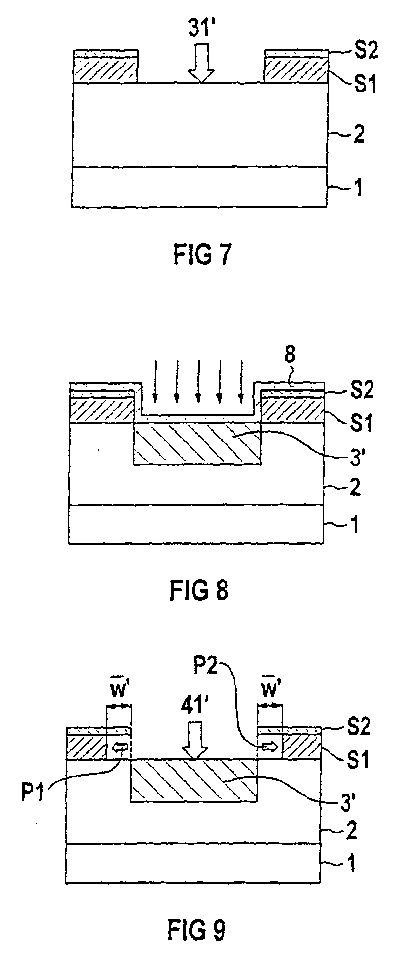

Fig. 7 das Einätzen eines Fensters in das Dünnschichtsystem zeigt,

Fig. 8 eine erste selektive Bearbeitung eines durch ein Fenster maskierten ersten Halbleiterteilgebiets zeigt,

Fig. 9 das Rücknehmen von Teilen des Dünnschichtsystems durch einen Unterätzprozeß zeigt,

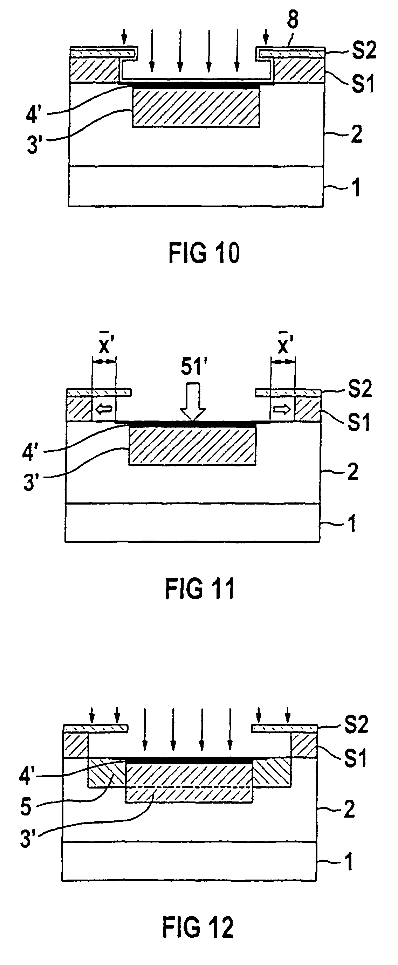

Fig. 10 eine zweite selektive Bearbeitung eines zweiten Halbleiterteilgebiets, welches maskiert wird von einem durch einen Unterätzprozeß vergrößerten Fenster, zeigt,

Fig. 11 als optionalen Schritt ein erneutes Rücknehmen von Teilen des Dünnschichtsystems durch einen Unterätzprozeß zeigt,

Fig. 12 als optionalen Schritt eine weitere, selektive Bearbeitung eines dritten Halbleiterteilgebiets, welches maskiert wird von einem durch einen erneuten Unterätzprozeß weiter vergrößerten Fenster, zeigt;

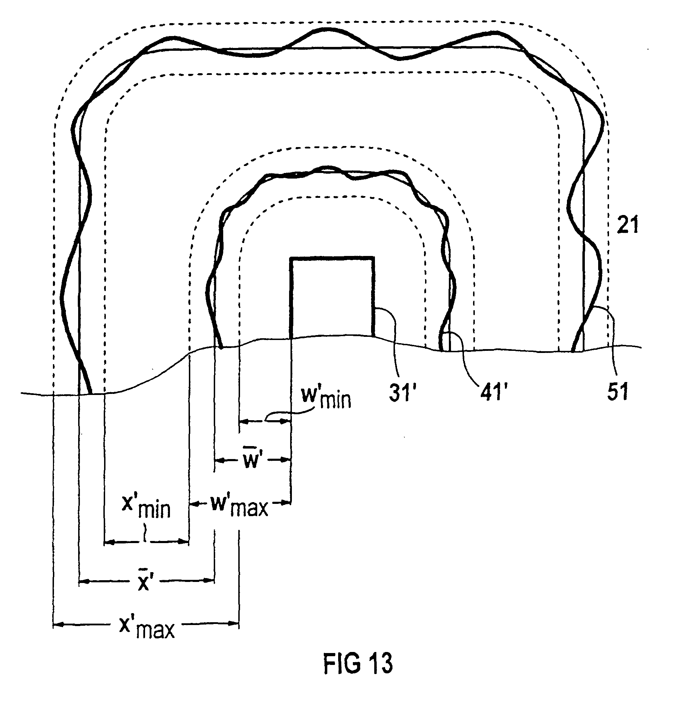

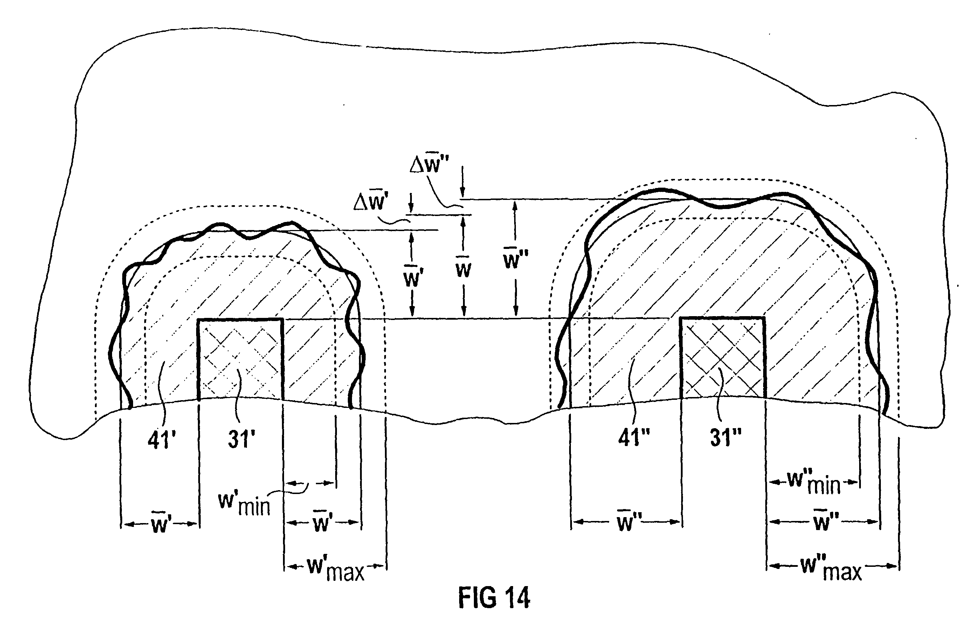

Fig. 13 und 14 jeweils in einer Draufsicht eines Ausschnitts der Oberfläche des Halbleitergebiets die während des Verfahrens verwendeten Fenster im Dünnschichtsystem zeigen.

In den Figuren sind sich entsprechende Teile mit denselben Bezugszeichen versehen.

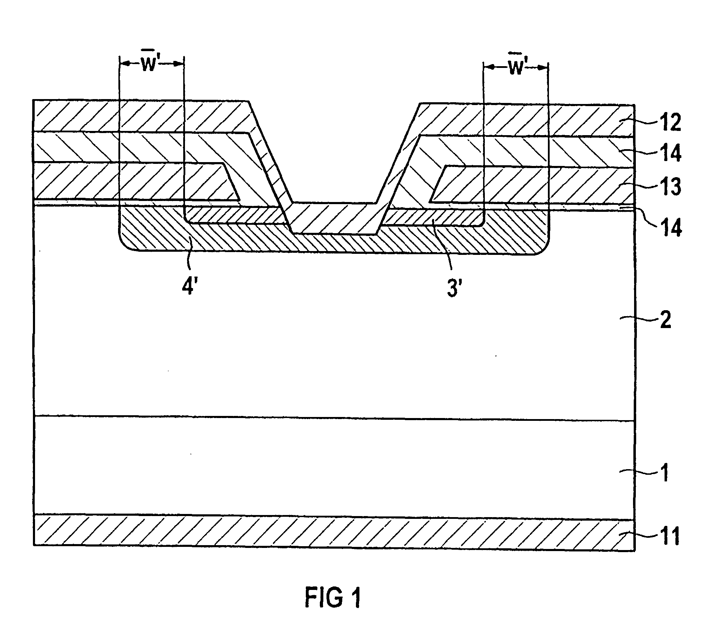

Fig. 1 zeigt eine aus der Silizium-Technologie an sich bekannte Halbleiterstruktur eines vertikalen MOSFET mit lateralem Kanalgebiet. Die Kontaktierung eines ein Source-Gebiet bildenden ersten Halbleiterteilgebiets 3' und eines ein Basisgebiet bildenden zweiten Halbleiterteilgebiets 4' wird über eine V-förmige Source-Metallisierung 12 realisiert, die durch das erste Halbleiterteilgebiet 3' hindurch in das zweite Halbleiterteilgebiet 4' geführt ist. Das aktive Gebiet des gezeigten Bauelements befindet sich im oberflächennahen Bereich des zweiten Halbleiterteilgebiets 4'. Der laterale Überstand des zweiten Halbleiterteilgebiets 4' nach jeder Seite über das erste Halbleiterteilgebiet 3' hinaus definiert eine Kanallänge, die einer mittleren Unterätztiefe $\bar{w}'$ entspricht. In Fig. 1 sind ferner mit der Nummer 1 das Substrat, mit Nummer 2 ein weiteres HL Gebiet, mit Nummer 11 die Drain-Elektrode, mit Nummer 13 die Gate-Elektrode und mit Nummer 14 der Gate-Isolator bezeichnet.

In Fig. 2 befindet sich auf der Oberfläche 21 eines Halbleitergebiets 2 das Dünnschichtsystem D, das sich vorzugsweise aus zwei Schichten S1 und S2 aus wenigstens einem Maskierungsmaterial zusammensetzt. In das Dünnschichtsystem D wird mit einem Ätzvorgang, der durch die fünf parallelen Pfeile ÄV angedeutet ist, und dessen Vorzugsrichtung mit der Oberflächennormalen ON der Oberfläche 21 des Halbleitergebietes 2 einen definierten Neigungswinkel θ einschließt, wenigstens ein Fenster 31' eingeätzt. Das wenigstens eine Fenster 31' weist innerhalb des Dünnschichtsystems eine Innenfläche 310' auf, die durch Schraffur angedeutet ist. Das eine Fenster 31' wird als Maskierung für eine selektive Bearbeitung eines ersten Teilgebiets 3' des Halbleitergebiets 2 verwendet. Durch einen erfindungsgemäßen Unterätzprozeß wird nun wenigstens eine Teilschicht des Dünnschichtsystems D in der Schichtebene annähernd gleichmäßig zurückgenommen. Der Unterätzprozeß greift dabei an der Innenfläche 310' des Fensters 31' im Dünnschichtsystem D an.

Wie in Fig. 3 dargestellt, vollzieht sich ein Abtrag zumindest einer Teilschicht des Dünnschichtsystems D nur in der Schichtebene des Dünnschichtsystems D und ist mit kurzen Pfeilen P1 und P2 angedeutet. Die Innenfläche 310' des Fensters 31' im Dünnschichtsystem D wird durch den Unterätzprozeß um einen Betrag $\bar{w}'$ annähernd gleichmäßig zurückgesetzt. Das auf diese Weise mindestens eine vergrößerte Fenster 41' im Dünnschichtsystem D wird als Maskierung für eine selektive Bearbeitung eines zweiten Halbleiterteilgebiets 4' des Halbleitergebiets 2 genutzt. Durch das gleichmäßige Unterätzen des Dünnschichtsystems D nach allen Seiten hin sind die Halbleiterteilgebiete 3' und 4' im Rahmen einer Genauigkeit des Unterätzprozesses ohne eine zusätzliche Maskierungsebene auf dem Halbleitergebiet 2 aufeinander ausgerichtet, und insbesondere auch zueinander zentriert. Optional kann noch ein Hochtemperaturschritt zur Ausheilung bzw. Aktivierung der selektiv bearbeiteten Halbleiterteilgebiete angeschlossen werden. Falls erforderlich, wird das Dünnschichtsystem D dazu zuvor entfernt.

Schließlich muß die Halbleiterstruktur noch in an sich bekannter Weise mit Hilfsschichten und Elektroden zur Kontaktierung versehen werden. Für das Beispiel einer MOSFET-Struktur bedeutet dies, daß Gate-Isolator und Gate-Elektrode aufgebracht sowie strukturiert werden müssen. Abschließend müssen noch Source- und Drain-Kontakte metallisiert werden. Die Justierungen der Gate-Elektrode und des Source-Kontaktes erfolgen mittels der durch das Dünnschichtsystem definierten Maske, vorzugsweise aber unabhängig vom Dünnschichtsystem direkt auf eine optische Justiermarke, die die Position des ersten Teilgebiets 3' des Halbleitergebiets 2 markiert.

In dem Verfahren gemäß der Erfindung besteht das Dünnschichtsystem mindestens aus einer ersten Dünnschicht S1 und einer zweiten Dünnschicht S2, wobei die beiden Dünnschichten vorzugsweise nacheinander auf die Oberfläche des zu strukturierenden Halbleitergebiets abgeschieden werden und aufgrund ihrer Materialeigenschaften sowohl gegeneinander als auch gegenüber dem Halbleitermaterial selektiv ätzbar sind. Dies bedeutet, daß für das Dünnschichtsystem ein Unterätzverfahren angegeben werden kann, in dem nur eine erste der mindestens zwei Dünnschichten angegriffen wird, nicht aber die zweite und/oder weitere Schichten des Dünnschichtsystems oder der Halbleiter. Durch diese selektive Ätzbarkeit wird bei geeigneter Wahl der Schichtreihenfolge nur eine Schicht durch den erfindungsgemäßen Unterätzprozeß angegriffen. Durch die Maskierung der ersten, ätzbaren Schicht S1 durch eine zweite oder weitere, nicht ätzbare Schichten bietet diese erste Schicht dem Unterätzprozeß nur innerhalb des mindestens einen zuvor eingeätzten Fensters 31' jeweils senkrecht zur Schichtebene des Dünnschichtsystems D liegende Angriffsflächen, die ein durch die ätzbare Schicht S1 definiertes Teilgebiet der Innenfläche 310' des eingeätzten Fensters 31' darstellen. Die selektiv ätzbare erste Schicht S1 des Dünnschichtsystems D besteht vorzugsweise aus Siliziumdioxid $SiO_2$, eine zweite Schicht S2 des Dünnschichtsystems D besteht vorzugsweise aus Polysilizium oder spannungsarmem $Si_3N_4$. Vorzugsweise wird der Unterätzprozeß mittels eines naßchemischen Ätzverfahrens durchgeführt, wobei ein vorgegebener Sollwert der Unterätztiefe über die Ätzdauer eingestellt wird. Vorzugsweise wird als naßchemisches Ätzmittel gepufferte Flußsäure (BHF) eingesetzt; es können aber auch ohne weiteres andere Substanzen eingesetzt werden, sofern sie eine selektive Ätzbarkeit des Dünnschichtsystems gewährleisten.

In einer vorteilhaften Ausgestaltungen des erfindungsgemäßen Verfahrens werden nach dem Öffnen des mindestens einen Fensters 31' im Dünnschichtsystem gemäß Fig. 4 und vor einem ersten selektiven Bearbeitungsschritt eines durch das mindestens eine Fenster 31' im Dünnschichtsystem definierte Halbleitergebiet im Bereich des mindestens einen Fensters 31' gemäß Fig. 6 zusätzlich unzerstörbare Ätzkanten 7 in die Oberfläche des Halbleitergebiets 2 eingeätzt. Auf diese Ätzkanten kann dann in späteren Verfahrensschritten justiert werden, falls beispielsweise, wie bei Silizium-Carbid, vor einem Hochtemperaturschritt zur Ausheilung der bearbeiteten Halbleiterteilgebiete das Dünnschichtsystem entfernt werden muß. Eine typische Ätztiefe liegt bei etwa 300 nm.

In einer besonders vorteilhaften Ausführungsform werden vor dem Einätzen der Justiermarken durch das Aufbringen einer weiteren Hilfsschicht 6 gemäß Fig. 5 Teile des von dem mindestens einen Fenster 31' freigelegten Halbleitergebiets 2 maskiert, so daß sie beim anschließenden Einätzen der Justiermarken vor einem Ätzangriff geschützt sind. Vorzugsweise wird diese Maskierung mittels einer Lackmaske vorgenommen, in die photolithographisch Ausnehmungen eingebracht werden, die das Dünnschichtsystem in denjenigen Bereichen freilegen, innerhalb derer sich jeweils ein Fenster 31' für das Einätzen einer Justiermarke befindet.

Die Figuren 7 bis 12 zeigen einen zweidimensionalen Querschnitt durch einen mit dem erfindungsgemäßen Verfahren bearbeiteten Halbleiter. Ein auf einem Substrat 1 angeordnetes Halbleitergebiet 2 weist an seiner Oberfläche eine erste Dünnschicht S1 und eine zweite Dünnschicht S2 auf, die nacheinander auf das Halbleitergebiet 2 abgeschieden worden sind. Nach dem in Fig. 7 angedeuteten Öffnen des Fensters 31' im Dünnschichtsystem kann in einer vorteilhaften Ausführung des erfindungsgemäßen Verfahrens gemäß Fig. 8 optional eine Streuschicht 8 auf die Oberfläche der zu bearbeitenden Struktur abgeschieden werden. Die Streuschicht kann dazu verwendet werden, das Ergebnis einer selektiven Bearbeitung des durch das mindestens eine Fenster 31' definierten ersten Halbleiterteilgebiets 3' in gewünschter Weise zu beeinflussen. Falls die Eigenschaften des ersten Halbleiterteilgebiets beispielsweise durch Ionenimplantation verändert werden sollen, so gewährleistet eine Streuschicht 8 eine Implantation der Fremdatome möglichst nahe an der Halbleiteroberfläche. Vorzugsweise wird das Material für die Streuschicht so gewählt, daß die Streuschicht bei einem folgenden Unterätzprozeß gemäß Fig. 9 des erfindungsgemäßen Verfahrens wieder vollständig entfernt wird. Besonders vorteilhaft ist die Verwendung von Siliziumdioxid ($SiO_2$) für die Streuschicht 8. Es kann, wie in Fig. 10 gezeigt, vor jedem weiteren selektiven Bearbeitungsschritt des Halbleitergebietes optional eine Streuschicht aufgebracht werden.

Die Figuren 11 und 12 zeigen eine weitere vorteilhafte Ausführung des erfindungsgemäßen Verfahrens. So können sich nach einem zweiten selektiven Bearbeitungsschritt eines zweiten Halbleitergebiets 4' des Halbleitergebiets 2 noch weitere Bearbeitungsschritte anschließen. In Fig. 11 ist ein zweiter Unterätzprozeß des Dünnschichtsystems dargestellt. In diesem weiteren Unterätzprozeß werden die Ränder des mindestens einen Fensters 41' (vgl. Fig. 9) wenigstens in einer Teilschicht S1 des Dünnschichtsystems um einen weiteren Betrag x' zurückgenommen. Das resultierende mindestens eine, vergrößerte Fenster 51 dient dann gemäß Fig. 12 als Maskierung für eine dritte selektive Bearbeitung eines Teilgebiets 5 des Halbleitergebiets 2.

Vorzugsweise ist das mindestens eine in das Dünnschichtsystem D eingeätzte Fenster 31' (vgl. Fig. 7) zumindest annähernd rechteck-, sechseck-, dreieck- oder kreisförmig. Vorzugsweise sind auch die Schichtdicken der Dünnschichten S1, S2 im Dünnschichtsystem D aufeinander abgestimmt. Die zweite Dünnchicht S2, welche dem Unterätzprozeß widersteht, ist einerseits dünn genug, um auch durch den nach Unterätzen der ersten Dünnschicht S1 entstehenden dachähnlichen Vorsprung im Dünnschichtsystem D hindurch eine selektive Bearbeitung des ersten Halbleitergebiets 2 vornehmen zu können. Andererseits muß die zweite Dünnschicht S2 dick genug sein, um mechanisch stabil zu bleiben. Ihre mechanische Stabilität bestimmt auch die maximal zulässige Unterätzung. Die Schichtdicke der ersten Dünnschicht S1 wird nach der Maßgabe gewählt, daß sie zusammen mit Schicht S2 eine ausreichend dicke Maskierung des Halbleitergebiets 2 für die durchzuführenden selektiven Bearbeitungsschritte bildet. Typischerweise sind hierfür Dicken zwischen 0,5 bis maximal 3 µm notwendig.

In einer besonders vorteilhaften Ausführungsform läßt sich durch Variation der Schichtdicken der Dünnschichten S1, S2 ein selektiver Bearbeitungsschritt des ersten Halbleitergebietes in besonderer Weise kontrollieren. Bei der Verwendung eines Fensters im Dünnschichtsystem, das die beschriebene Struktur eines vorspringenden Daches aufweist, werden zwei verschiedene Teilgebiete des ersten Halbleitergebietes definiert, die somit allein durch Variation der Schichtdicken unabhängig voneinander in einem einzigen selektiven Bearbeitungsschritt bearbeitet werden können. Selbstverständlich ist es aber auch möglich, nach einem Unterätzprozeß und vor einer selektiven Bearbeitung des Halbleitergebietes die unterätzten Teile der zweiten Dünnschicht S2 zu entfernen.

Das gewählte Beispiel einer vertikalen MOSFET-Struktur dient lediglich zur Erläuterung der Erfindung und soll nicht als eine Beschränkung des Verfahrens auf diese Struktur verstanden werden. Selbstverständlich eignet sich das Verfahren auch zur Herstellung anderer Halbleiterstrukturen, insbesondere für solche Strukturen, bei denen die Justierung von Halbleiterteilgebieten relativ zueinander kritisch für Eigenschaften des resultierenden Bauelements sind, und es insbesondere darauf ankommt, daß die Halbleiterteilgebiete zueinander zentriert sind.

Das erfindungsgemäße Verfahren ist für die Bearbeitung von Halbleiterstrukturen aus Silizium-Carbid geeignet, da bekannte Verfahren, die auf unterschiedlicher Diffusivität von Fremdatomen beruhen, nicht in Frage kommen.

Die besonderen Vorteile des erfindungsgemäßen Verfahrens lassen sich anhand der Figuren 13 und 14 verdeutlichen. In einer Draufsicht auf die Oberfläche 21 des Halbleitergebiets 2 sind hier ein bzw. zwei verschiedene Fenster skizziert, die als Maskierung für sukzessive, selektive Bearbeitungsschritte des Halbleitergebiets 2 verwendet werden. Fig. 13 zeigt ein Fenster 31' im Dünnschichtsystem D, das durch sukzessives erfindungsgemäßes Unterätzen auf die Fenster 41' bzw. 51 erweitert wird. Die durch eine geschlängelte Linie angedeuteten jeweiligen Ränder des Fensters 41' bzw. 51 variiert entlang des Fensterrandes zwischen einer minimalen Unterätztiefe $w'_{min}$ bzw. $x'_{min}$ und einer maximalen Unterätztiefe $w'_{max}$ bzw. $x'_{max}$. In einer vorteilhaften

Ausführungsform wird der Unterätzprozeß im Rahmen einer Genauigkeit von 10 nm gleichmäßig ausgeführt, so daß nach dem *n*-ten Unterätzschritt die tatsächliche Unterätztiefe innerhalb des mit dem n-ten Schritt geätzten Fensters um nicht mehr als ($n \times 10$) nm von einer mittleren Unterätztiefe

$$\bar{w}' = \frac{w'_{max} + w'_{min}}{2} \text{ bzw. } \bar{x}' = \frac{x'_{max} + x'_{min}}{2}$$

abweicht.

In Fig. 14 ist dargestellt, daß die mittleren Unterätztiefen $\bar{w}'$, $\bar{w}''$, ... in $m$ parallel zueinander unterätzten Fenstern 41', 41' ', ... von einem allen Fenstern gemeinsamen arithmetischen Mittelwert

$$\bar{w} = \frac{1}{m}\cdot(\bar{w}' + \bar{w}'' + \cdots)$$

aus den mittleren Unterätztiefen jeweils um nicht mehr als 10 nm abweichen.

Besonders vorteilhaft ist, daß sich das arithmetische Mittel $\bar{w}$ der mittleren Unterätztiefen $\bar{w}'$, $\bar{w}''$, ... sämtlicher Fenster auf 100 nm genau einem vorgegebenen Sollwert angleichen läßt.

In Fig. 14 sind ferner mit der Nummer 31" ein zweites eingeätztes Fenster im Dünnmschichtsystem, mit dem Zeichen $w''_{min}$ und $w''_{max}$ die minimale und maximale Unterätztiefe bei der 1. Unterätzung eines zweiten Fensters und mit den Zeichen $\Delta\bar{w}'$ und $\Delta\bar{w}''$ die Abweichungen beim ersten und zweiten Fenster vom Mittelwet der mittleren Unterätztiefen bezeichnet.

Das vorstehend beschriebene erfindungsgemäße Verfahren ist für SiC-Material anwendbar.

## Patentansprüche

1. Verfahren zur Herstellung von Halbleiterstrukturen, bei dem

   a) ein Dünnschichtsystem (D) aus mindestens zwei Teilschichten (S1, S2) auf die Oberfläche (21) eines Halbleitergebiets (2) abgeschieden wird, wobei zumindest für die an die Oberfläche (21) des Halbleitergebiets (2) unmittelbar angrenzende erste Teilschicht (S1) ein Oxidmaterial vorgesehen ist, und für das Halbleitergebiet (2) Silizium-Carbid verwendet wird,
   b) mit einem Ätzverfahren mindestens ein bis zur Oberfläche (21) des Halbleitergebiets (2) reichendes Fenster (31', 31") in das Dünnschichtsystem (D) eingeätzt wird,
   c) das mindestens eine Fenster (31', 31") im Dünnschichtsystem (D) für eine erste selektive Bearbeitung eines Teilgebiets (3) des Halbleitergebiets (2) genutzt wird,

   d) durch einen Unterätz-Prozeß wenigstens in der ersten Teilschicht (S1) des Dünnschichtsystems (D) der Rand (310') des mindestens einen Fensters (31', 31") in der Schichtebene jeweils annähernd gleichmäßig um einen Betrag zurückgenommen wird, der einer mittleren Unterätz-Tiefe ($\bar{w}'$) entspricht,
   e) das mindestens eine durch Unterätzen vergrößerte Fenster (41', 41") im Dünnschichtsystem (D) für eine zweite selektive Bearbeitung eines weiteren Teilgebiets (4') des Halbleitergebiets (2) genutzt wird, und
   f) das Dünnschichtsystem (D) entfernt wird.

2. Verfahren nach Anspruch 1, **dadurch gekennzeichnet, daß** zur Ausbildung des Dünnschichtsystems die erste Dünnschicht (S1) und eine zweite Dünnschicht (S2) nacheinander abgeschieden werden, die aufgrund ihrer Materialeigenschaften selektiv ätzbar sind, ohne die jeweils andere Dünnschicht und/oder das Halbleitergebiet (2) anzugreifen.

3. Verfahren nach einem der vorhergehenden Ansprüche, **dadurch gekennzeichnet , daß** das wenigstens teilweise Unterätzen des Dünnschichtsystems (S1, S2) durch naßchemisches Ätzen vorgenommen wird, wobei ein vorgegebener Sollwert der Unterätz-Tiefe über die Ätzdauer eingestellt wird.

4. Verfahren nach Anspruch 3, **dadurch gekennzeichnet , daß** als ein naßchemisches Ätzmittel gepufferte Flußsäure (BHF) vorgesehen wird.

5. Verfahren nach einem der vorhergehenden Ansprüche, **dadurch gekennzeichnet, daß** zum Einätzen des wenigstens einen Fensters (31', 31") in das Dünnschichtsystems ein Ätzverfahren vorgesehen wird, bei dem der Materialabtrag im Wesentlichen in einer Vorzugsrichtung erfolgt, die einen definierten Neigungswinkel (θ) mit der Oberflächennormalen (ON) der Oberfläche (21) des Halbleitergebiets (2) einschließt.

6. Verfahren nach einem der vorhergehenden Ansprüche, **dadurch gekennzeichnet, daß** nach dem Ätzen des Dünnschichtsystems (S1, S2) zusätzlich optisch erkennbare und gegenüber einer Ausheilung der Halbleiterstruktur beständige Ätzkanten (7) in die Oberfläche (21) des Halbleitergebiets (2) eingeätzt werden.

7. Verfahren nach einem der vorhergehenden Ansprüche, **dadurch gekennzeichnet, daß** vor einer Bearbeitung des Halbleitergebiets (2) eine Streuschicht (8) wenigstens auf Teile der Oberfläche (21) des Halbleitergebiets aufgebracht wird.

**8.** Verfahren nach Anspruch 7, **dadurch gekennzeichnet, daß** für die Streuschicht $SiO_2$ vorgesehen wird.

**9.** Verfahren nach einem der Ansprüche 2 bis 8, **dadurch gekennzeichnet, daß** nach einem Unterätzen der ersten Dünnschicht (S1) die zweite Dünnschicht (S2) zumindest teilweise entfernt wird.

**10.** Verfahren nach einem der vorhergehenden Ansprüche, **gekennzeichnet durch** einen Unterätzprozeß, bei dem

a) in dem mindestens einem vergrößerten Fenster (41', 41") die mittlere Unterätz-Tiefe ($\bar{w}'$, $\bar{w}"$) dem arithmetischen Mittel aus einer minimalen Unterätz-Tiefe ($w'_{min}$, $w"_{min}$) und einer maximalen Unterätz-Tiefe ($w'_{max}$, $w"_{max}$) entspricht;
b) in dem mindestens einen Fenster die Abweichung der tatsächlichen Unterätz-Tiefe von der mittleren Unterätz-Tiefe ($\bar{w}'$, $\bar{w}"$) unterhalb eines für alle Fenster gemeinsam vorgegebenen Wertes liegt.

**11.** Verfahren nach Anspruch 10, **gekennzeichnet durch** einen Unterätzprozeß zur Ausbildung mehrerer Fenster, bei dem

a) ein Mittelwert ($\bar{w}$) eingehalten wird, der dem arithmetischen Mittel aus den mittleren Unterätz-Tiefen ($\bar{w}'$, $\bar{w}"$) sämtlicher Fenster entspricht;
b) wobei eine Abweichung ($\Delta\bar{w}'$, $\Delta\bar{w}"$) der mittleren Unterätz-Tiefe ($\bar{w}'$, $\bar{w}"$) von diesem Mittelwert ($\bar{w}$) für jedes der Fenster (41', 41' ') unterhalb eines vorgegebenen Wertes eingehalten wird.

**12.** Verfahren nach Anspruch 11, **gekennzeichnet durch** einen Unterätzprozeß, bei dem der Mittelwert ($\bar{w}$) aus den mittleren Unterätz-Tiefen ($\bar{w}'$, $\bar{w}"$) sämtlicher Fenster (41', 41") höchstens um ein Längenmaß, welches einer Justagetoleranz entspricht, von einem vorgegebenen Sollwert der Unterätz-Tiefe abweicht.

**13.** Verfahren nach einem der Ansprüche 10 bis 12, **dadurch gekennzeichnet , daß** in jedem Fenster (41', 41") eine Abweichung der tatsächlichen Unterätz-Tiefe von der mittleren Unterätz-Tiefe ($\bar{w}'$, $\bar{w}"$) von jeweils weniger als 10 nm eingehalten wird.

**14.** Verfahren nach einem der Ansprüche 11 bis 13, **dadurch gekennzeichnet, daß** in jedem der Fenster (41', 41") eine Abweichung ($\Delta\bar{w}'$, $\Delta\bar{w}"$) der mittleren Unterätz-Tiefe ($\bar{w}'$, $\bar{w}"$) vom Mittelwert ($\bar{w}$) aus den mittleren Unterätz-Tiefen ($\bar{w}'$, $\bar{w}"$) sämtlicher Fenster von jeweils weniger als 10 nm eingehalten wird.

**15.** Verfahren nach einem der Ansprüche 12 bis 14, **dadurch gekennzeichnet, daß** eine Abweichung des Mittelwerts ($\bar{w}$) aus den mittleren Unterätz-Tiefen ($\bar{w}'$, $\bar{w}"$) sämtlicher Fenster (41', 41") vom vorgegebenen Sollwert der Unterätz-Tiefe von weniger als 100 nm eingehalten wird.

**16.** Verfahren nach einem der vorhergehenden Ansprüche, **dadurch gekennzeichnet, daß** zur ersten und/oder weiteren selektiven Bearbeitung des Halbleitergebiets (2) Fremdatome mittels Ionenimplantation in das Halbleitergebiet (2) eingebracht werden.

**17.** Verfahren nach einem der vorhergehenden Ansprüche, **gekennzeichnet durch** mehrfache Anwendung einer Abfolge sukzessiver Verfahrensschritte, die jeweils wenigstens aus einem Unterätzen des Dünnschichtsystems (D) und dem Benutzen der resultierenden vergrößerten Fenster (41', 41", 51) in der Maskierung des Halbleitergebiets (2) für eine selektive Bearbeitung des besagten Halbleitergebiets besteht.

## Claims

**1.** Method for fabricating semiconductor structures, in which

a) a thin-film system (D) comprising at least two partial layers (S1, S2) is deposited onto the surface (21) of a semiconductor region (2), an oxide material being provided at least for the first partial layer (S1) which directly adjoins the surface (21) of the semiconductor region (2), and silicon carbide being used for the semiconductor region (2),
b) at least one window (31', 31") extending down to the surface (21) of the semiconductor region (2) is etched into the thin-film system (D) by an etching method,
c) the at least one window (31', 31") in the thin-film system (D) is utilized for a first selective processing of a partial region (3) of the semiconductor region (2),
d) by means of an undercutting process, at least in the first partial layer (S1) of the thin-film system (D), the edge (310') of the at least one window (31', 31") is drawn back in the layer plane in each case approximately uniformly by an amount corresponding to a mean undercutting depth ($\bar{w}'$),
e) the at least one window (41', 41") that has been enlarged by undercutting in the thin-film system (D) is utilized for a second selective processing of a further partial region (4') of the semiconductor region (2), and

f) the thin-film system (D) is removed.

2. Method according to Claim 1, **characterized in that**, in order to form the thin-film system, the first thin film (S1) and a second thin film (S2) are deposited successively, which thin films can be etched selectively on account of their material properties, without the respective other thin film and/or the semiconductor region (2) being attacked.

3. Method according to one of the preceding claims, **characterized in that** the at least partial undercutting of the thin-film system (S1, S2) is performed by wet-chemical etching, a predetermined desired value of the undercutting depth being set by way of the etching duration.

4. Method according to Claim 3, **characterized in that** buffered hydrofluoric acid (BHF) is provided as a wet-chemical etchant.

5. Method according to one of the preceding claims, **characterized in that**, in order to etch the at least one window (31', 31") into the thin-film system, an etching method is provided in which the material is removed essentially in a preferred direction which includes a defined angle ($\theta$) of inclination with the normal (ON) to the surface (21) of the semiconductor region (2).

6. Method according to one of the preceding claims, **characterized in that** after the etching of the thin-film system (S1, S2), optically identifiable etching edges (7) which are resistant to annealing of the semiconductor structure are additionally etched into the surface (21) of the semiconductor region (2).

7. Method according to one of the preceding claims, **characterized in that**, prior to a processing of the semiconductor region (2), a screen layer (8) is applied at least to parts of the surface (21) of the semiconductor region.

8. Method according to Claim 7, **characterized in that** $SiO_2$ is provided for the screen layer.

9. Method according to one of Claims 2 to 8, **characterized in that** after undercutting of the first thin film (S1), the second thin film (S2) is at least partially removed.

10. Method according to one of the preceding claims, **characterized by** an undercutting process in which

    a) in the at least one enlarged window (41', 41"), the mean undercutting depth ($\bar{w}$, $\bar{w}$") corresponds to the arithmetic mean formed from a minimum undercutting depth ($w'_{min}$, $w'_{min}$) and a maximum undercutting depth ($w'_{max}$, $w''_{max}$) ;

    b) in the at least one window, the deviation of the actual undercutting depth from the mean undercutting depth ($\bar{w}$, $\bar{w}$") lies below a value which is predetermined jointly for all of the windows.

11. Method according to Claim 10, **characterized by** an undercutting process for forming a plurality of windows in which

    a) a mean value ($\bar{w}$) is adhered to which corresponds to the arithmetic mean formed from the mean undercutting depths ($\bar{w}$', $\bar{w}$") of all the windows;

    b) where a deviation ($\Delta\bar{w}$', $\Delta\bar{w}$") of the mean undercutting depth ($\bar{w}$', $\bar{w}$") from this mean value ($\bar{w}$) for each of the windows (41', 41") below a predetermined value is adhered to.

12. Method according to Claim 11, **characterized by** an undercutting process in which the mean value ($\bar{w}$) formed from the mean undercutting depths ($\bar{w}$', $\bar{w}$") of all the windows (41', 41") deviates from a predetermined desired value of the undercutting depth at most by a linear dimension which corresponds to an alignment tolerance.

13. Method according to one of Claims 10 to 12, **characterized in that** a deviation of the actual undercutting depth from the mean undercutting depth ($\bar{w}$', $\bar{w}$") of in each case less than 10 nm is adhered to in each window (41', 41") .

14. Method according to one of Claims 11 to 13, **characterized in that** a deviation ($\Delta\bar{w}$', $\Delta\bar{w}$") of the mean undercutting depth ($\bar{w}$', $\bar{w}$") from the mean value ($\bar{w}$) formed from the mean undercutting depths ($\bar{w}$', $\bar{w}$") of all the windows of in each case less than 10 nm is adhered to in each of the windows (41', 41").

15. Method according to one of Claims 12 to 14, **characterized in that** a deviation of the mean value ($\bar{w}$) formed from the mean undercutting depths ($\bar{w}$', $\bar{w}$") of all the the windows (41', 41") from the predetermined desired value of the undercutting depth of less than 100 nm is adhered to.

16. Method according to one of the preceding claims, **characterized in that**, for the first and/or further selective processing of the semiconductor region (2), impurity atoms are introduced into the semiconductor region (2) by means of ion implantation.

17. Method according to one of the preceding claims, **characterized by** multiple application of a sequence of successive method steps which in each case comprises at least an undercutting of the thin-film system (D) and the use of the resulting enlarged windows (41', 41' ', 51) in the masking of the semiconductor region (2) for a selective processing of said semiconductor region.

## Revendications

1. Procédé de production de structure à semi-conducteurs, dans lequel

a) on dépose un système (D) en couches minces, constitué d'au moins deux couches (S1, S2) partielles, à la surface (21) d'une zone (2) semi-conductrice, une matière d'oxyde étant prévue au moins pour la première couche (S1) partielle immédiatement adjacente à la surface (21) de la zone (2) semi-conductrice, et du carbure de silicium étant utilisé pour la zone (2) semi-conductrice,
b) par un procédé d'attaque, on ménage dans le système (D) en couches minces au moins une fenêtre (31', 31") allant jusqu'à la surface (21) de la zone (2) semi-conductrice,
c) on utilise la au moins une fenêtre (31', 31") dans le système (D) en couches minces pour un premier traitement sélectif d'une zone (3) partielle de la zone (2) semi-conductrice,
d) par une opération d'attaque latérale, au moins dans la première couche (S1) partielle du système (D) en couches minces, on réduit le bord (310') de la au moins une fenêtre (31', 31 ") dans le plan de la couche respectivement à peu près uniformément d'un montant qui correspond à une profondeur ($\bar{\omega}'$) moyenne d'attaque latérale,
e) on utilise la au moins une fenêtre (41', 41") agrandie par attaque latérale dans le système (D) en couches minces pour un deuxième traitement sélectif d'une autre zone (4') partielle de la zone (2) semi-conductrice et
f) on élimine le système (D) en couches minces.

2. Procédé suivant la revendication 1, **caractérisé en ce que**, pour constituer le système en couches minces, on dépose la première couche (S1) mince et une deuxième couche (S2) mince l'une après l'autre, lesquelles peuvent être attaquées sélectivement en raison de leurs propriétés de matière sans que respectivement l'autre couche mince et/ou la zone (2) semi-conductrice soit attaquée.

3. Procédé suivant l'une des revendications précédentes, **caractérisé en ce que** l'on effectue l'attaque latérale au moins partielle du système (S1, S2) en couches minces par attaque chimique en voie humide en réglant une valeur de consigne prescrite de la profondeur de l'attaque latérale par la durée d'attaque.

4. Procédé suivant la revendication 3, **caractérisé en ce que** l'on prévoit comme agent d'attaque chimique en voie humide de l'acide fluorhydrique (BHF) tamponné.

5. Procédé suivant l'une des revendications précédentes, **caractérisé en ce que** pour ménager par attaque la au moins une fenêtre (31', 31 ") dans le système en couches minces, on prévoit un procédé d'attaque dans lequel l'enlèvement de matière s'effectue sensiblement dans une direction préférée qui fait un angle (θ) d'inclinaison défini avec la normale (ON) à la surface (21) de la zone (2) semi-conductrice.

6. Procédé suivant l'une des revendications précédentes, **caractérisé en ce que**, après l'attaque du système (S1, S2) en couches minces, on ménage en outre par attaque dans la surface de la zone (2) semi-conductrice des bords (7) d'attaque que l'on peut reconnaître visuellement et qui résistent à un recuit de la structure à semi-conducteurs.

7. Procédé suivant l'une des revendications précédentes, **caractérisé en ce que**, avant le traitement de la zone (2) semi-conductrice, on dépose une couche (8) de dispersion au moins sur des parties de la surface (21) de la zone semi-conductrice.

8. Procédé suivant la revendication 7, **caractérisé en ce que** l'on prévoit du $SiO_2$ pour la couche de dispersion.

9. Procédé suivant l'une des revendications 2 à 8, **caractérisé en ce que**, après une attaque latérale de la première couche (S1) mince, on élimine au moins en partie la deuxième couche (S2) mince.

10. Procédé suivant l'une des revendications précédentes, **caractérisé par** une opération d'attaque latérale dans laquelle

a) dans la au moins une fenêtre (41', 41") agrandie, la profondeur ($\bar{\omega}'$, $\bar{\omega}''$) moyenne d'attaque latérale correspond à la moyenne arithmétique d'une profondeur ($\bar{\omega}'_{min}$, $\bar{\omega}''_{min}$) minimum d'attaque latérale et d'une profondeur ($\bar{\omega}'_{max}$, $\bar{\omega}''_{max}$) maximum d'attaque latérale ;
b) dans la au moins une fenêtre, l'écart des profondeurs réelles d'attaque latérale à la profondeur ($\bar{\omega}'$, $\bar{\omega}''$) moyenne d'attaque latérale est inférieur à une valeur prescrite en commun pour toutes les fenêtres.

**11.** Procédé suivant la revendication 10, **caractérisé par** une opération d'attaque latérale en vue de former plusieurs fenêtres dans laquelle

a) on respecte une valeur ($\bar{\omega}$) moyenne qui correspond à la moyenne arithmétique des profondeurs ($\bar{\omega}'$, $\bar{\omega}''$) moyennes d'attaque latérale de toutes les fenêtres ;
b) un écart ($\Delta\bar{\omega}'$, $\Delta\bar{\omega}''$) des profondeurs ($\bar{\omega}'$, $\bar{\omega}''$) moyennes d'attaque latérale à cette valeur ($\bar{\omega}$) moyenne pour chacune des fenêtres (41', 41") étant maintenu inférieur à une valeur prescrite.

**12.** Procédé suivant la revendication 11, **caractérisé par** une opération d'attaque latérale dans laquelle la valeur ($\bar{\omega}$) moyenne des profondeurs ($\bar{\omega}'$, $\bar{\omega}''$) moyennes d'attaque latérale de toutes les fenêtres (41', 41") s'écarte au plus d'une dimension en longueur qui correspond à une tolérance d'ajustage d'une valeur de consigne prescrite de la profondeur d'attaque latérale.

**13.** Procédé suivant l'une des revendications 10 à 12, **caractérisé en ce que** dans chaque fenêtre (41', 41") on respecte un écart des profondeurs réelles d'attaque latérale à la profondeur ($\bar{\omega}'$, $\bar{\omega}''$) moyenne d'attaque latérale de respectivement moins de 10 nm.

**14.** Procédé suivant l'une des revendications 11 à 13, **caractérisé en ce que** dans chacune des fenêtres (41', 41 ") on respecte un écart ($\Delta\bar{\omega}'$, $\Delta\bar{\omega}''$) de la profondeur ($\bar{\omega}'$, $\bar{\omega}''$) moyenne d'attaque latérale à la valeur ($\bar{\omega}$) moyenne des profondeurs ($\bar{\omega}'$, $\bar{\omega}''$) moyennes d'attaque latérale de toutes les fenêtres de respectivement moins de 10 nm.

**15.** Procédé suivant l'une des revendications 12 à 14, **caractérisé en ce que** l'on respecte un écart de la valeur ($\bar{\omega}$) moyenne des profondeurs ($\bar{\omega}'$, $\bar{\omega}''$) moyennes d'attaque latérale de toutes les fenêtres (41', 41") à là valeur de consigne prescrite de la profondeur d'attaque latérale de moins de 100 nm.

**16.** Procédé suivant l'une des revendications précédentes, **caractérisé en ce que** pour le premier et/ou d'autres traitements sélectifs de la zone (2) semi-conductrice, on introduit des atomes étrangers au moyen d'une implantation d'ions dans la zone (2) semi-conductrice.

**17.** Procédé suivant l'une des revendications précédentes, **caractérisé par** une utilisation plusieurs fois d'une suite de stades successifs de procédé, qui est constitué respectivement d'au moins une attaque latérale du système (D) en couches minces et de l'utilisation des fenêtres (41', 41", 51) agrandies qui s'ensuit dans le masquage de la zone (2) semi-conductrice, pour un traitement sélectif de ladite zone semi-conductrice.

FIG 1

FIG 2

FIG 3

31'

S2

S1

2

1

**FIG 4**

6

S2

S1

2

1

**FIG 5**

7  7

31'

S2

S1

2

1

**FIG 6**

**31'**

S2
S1
2
1

**FIG 7**

**8**

S2
S1
3'
2
1

**FIG 8**

**P2**

$\overline{w'}$    **41'**    $\overline{w'}$

S2
S1

P1

3'
2
1

**FIG 9**

**FIG 10**

**FIG 11**

**FIG 12**

FIG 13

FIG 14

EP 1 002 334 B1